# EUROPEAN PATENT APPLICATION

(11) **EP 4 418 487 A1**
(43) Date of publication of application: **21.08.2024**
(21) Application number: 22885643.1
(22) Date of filing: 10.10.2022
(51) Int. Cl.: H02J 7/00

(54) **CHARGING PARAMETER ADJUSTMENT METHOD, CONTROLLER, TERMINAL DEVICE, AND STORAGE MEDIUM**

(30) Priority: 29.10.2021 CN 202111276486
(71) Applicant: ZTE Corporation, Shenzhen, Guangdong 518057 (CN)
(72) Inventor: CUI, Xiaochuan, Shenzhen, Guangdong 518057 (CN)
(74) Representative: Savi, Massimiliano
(86) International application number: PCT/CN2022/124407
(87) International publication number: WO 2023/071764

(57) **Abstract**

Embodiments of the present application provide a charging parameter adjustment method, a controller, a terminal device, and a storage medium. The method comprises: obtaining the current battery internal resistance of a battery and a level increment voltage between two adjacent stages of output level (S 100); according to the battery internal resistance and the level increment voltage, obtaining a parameter fluctuation amplitude of an electrical signal of a charging assembly under the level increment voltage (S200); obtaining a current electrical signal parameter of the charging assembly and a threshold parameter corresponding to the electrical signal parameter (S300); and obtaining a target output level of a charger according to the electrical signal parameter, the threshold parameter, and the parameter fluctuation amplitude, and adjusting the current output level of the charger to the target output level (S400).

## Description

### CROSS-REFERENCE TO RELATED APPLICATION

This application is filed on the basis of the Chinese patent application No. 202111276486.8 filed October 29, 2021, and claims priority of the Chinese patent application, the entire contents of which are incorporated herein by reference.

### TECHNICAL FIELD

The present disclosure relates to, but is not limited to, the field of charging, in particular to a method for regulating a charging parameter, a controller, a terminal device, and a computer-readable storage medium.

### BACKGROUND

Currently, the internal resistance of the battery in a terminal device will change due to the influence of power level, the temperature, or aging degree of the battery. In addition, different types of batteries would also tend to have a large difference between the internal resistances at the factory. As a result, the internal resistance of the battery is uncertain. The uncertainty in the internal resistance of the battery affects the accuracy of the control on the charging parameters, which thus can easily lead to overcurrent and overvoltage or a failure for charging parameters to reach an optimal state.

### SUMMARY

The following is a summary of the subject matter described herein. This summary is not intended to limit the scope of protection of the claims.

Provided are a method for regulating a charging parameter, a controller, a terminal device, and a computer-readable storage medium in some embodiments of the present disclosure.

According to an embodiment of the present disclosure, a method for regulating a charging parameter is provided. The method is applied to a controller. The controller is in a communicative connection with a charging assembly. The charging assembly includes a battery and a charger configured to charge the battery. The charger is configured with a plurality of output levels. The method includes: acquiring a present battery internal resistance of the battery and an inter-level voltage difference between two adjacent output levels; acquiring a parameter fluctuation amplitude of an electrical signal of the charging assembly under the inter-level voltage difference, according to the internal resistance of the battery and the inter-level voltage difference; acquiring a present electrical signal parameter of the charging assembly and a threshold parameter corresponding to the electrical signal parameter; and acquiring a target output level of the charger according to the electrical signal parameter, the threshold parameter and the parameter fluctuation amplitude, and regulating a present output level of the charger to the target output level.

According to another embodiment of the present disclosure, a controller is provided. The controller includes a memory, a processor, and a computer program stored in the memory and executable by the processor which, when executed by the processor causes the processor to carry out the method as described above.

According to yet another embodiment of the present disclosure, a terminal device is provided. The terminal device includes the controller as described above.

According to yet another embodiment of the present disclosure, a computer-readable storage medium is provided. The computer-readable storage medium stores a computer-executable instruction which, when executed by a processor causes the processor to carry out the method as described above.

Other features and advantages of the present disclosure will be illustrated in the following description, and in part will be apparent from the description, or may be understood by practicing the present disclosure. The objects and other advantages of the present disclosure can be achieved and obtained by the structure particularly set forth in the description, claims, and drawings.

### BRIEF DESCRIPTION OF DRAWINGS

The drawings are intended to provide a further understanding of the technical scheme of the present disclosure, and constitute a part of the specification, and they are intended to illustrate the technical scheme of the present disclosure in conjunction with the embodiments of the present disclosure, but are not intended to limit the technical scheme of the present disclosure.
FIG. 1 depicts a schematic diagram showing a controller configured to carry out a method for regulating a charging parameter according to an embodiment of the present disclosure;
FIG. 2 depicts a flowchart showing a method for regulating a charging parameter according to an embodiment of the present disclosure;
FIG. 3 depicts a flowchart showing an acquisition of the battery internal resistance in a method for regulating a charging parameter according to an embodiment of the present disclosure;
FIG. 4 depicts a flowchart showing an acquisition of the battery internal resistance in a method for regulating a charging parameter according to another embodiment of the present disclosure;
FIG. 5 depicts a flowchart showing an acquisition of the battery internal resistance in a method for regulating a charging parameter according to another embodiment of the present disclosure;
FIG. 6 depicts a flowchart showing a calculation of parameter fluctuation amplitude during the stable constant current stage in a method for regulating a charging parameter according to an embodiment of the present disclosure;
FIG. 7 depicts a flowchart showing a calculation of the target output level in a method for regulating a charging parameter according to an embodiment of the present disclosure;
FIG. 8 depicts a flowchart showing a calculation of the target output level in a method for regulating a charging parameter according to another embodiment of the present disclosure;
FIG. 9 depicts a flowchart showing a calculation of the target output level in a method for regulating a charging parameter according to another embodiment of the present disclosure; and
FIG. 10 depicts a flowchart showing a selection of the target output level from a plurality of candidate levels in a method for regulating a charging parameter according to an embodiment of the present disclosure.

### DETAILED DESCRIPTION

The purpose, technical scheme, and advantages of the present disclosure will become apparent through the following description for various embodiments in conjunction with the drawings. It should be understood that the embodiments described here are intended for illustration but are not limitation to the present disclosure.

Although the devices are shown with individual functional modules in the schematic diagram and the logical sequences are shown in the flow chart, in some cases, the devices can have different modules than those shown and the steps can be executed in a different order than those shown. The terms "first" and "second", if used in the description, claims, and drawings are intended to distinguish similar objects, and do not necessarily imply any specific order or sequence.

In the related technology, the internal resistance of the battery in a terminal device will change due to the influence of power level, the temperature, or the aging degree of the battery. For example, the internal resistance of the same type of batteries will change according to, but not limited to, the following three conditions. First, the internal resistance of the battery will increase as the battery power level increases. Second, the internal resistance of the battery will increase as the temperature of the battery decreases. And third, the internal resistance of the battery will increase as the battery ages. In addition, different types of batteries would also tend to have a large difference between the internal resistances at the factory. As a result, the internal resistance of the battery is uncertain. The uncertainty in the internal resistance of the battery affects the accuracy of the controlling software on the charging parameters, which thus can easily lead to overcurrent and overvoltage or a failure for charging parameters to reach an optimal state. In addition, the battery calibration data is affected by floating voltage, only a relatively close impedance value can be found. However, it can not guarantee that the software voltage regulation algorithm is still accurate after the battery is aged.

In view of this, there is provided a method for regulating a charging parameter, a controller, a terminal device, and a computer-readable storage medium in some embodiments of the present disclosure. The method is applied to a controller. The controller is in a communicative connection with a charging assembly. The charging assembly includes a battery and a charger configured to charge the battery. The charger is configured with a plurality of output levels. The method includes but is not limited to the following operations. The controller first acquires a present battery internal resistance of the battery and an inter-level voltage difference between two adjacent output levels. Then, the controller calculates a parameter fluctuation amplitude of an electrical signal of the charging assembly under the inter-level voltage difference, according to the internal resistance of the battery and the inter-level voltage difference. Then, the controller acquires a present electrical signal parameter of the charging assembly and a threshold parameter corresponding to the electrical signal parameter. Finally, the controller acquires a target output level of the charger according to the electrical signal parameter, the threshold parameter, and the parameter fluctuation amplitude, and regulates a present output level of the charger to the target output level. According to an embodiment of the present disclosure, the internal resistance of the battery is calculated, and the parameter fluctuation amplitude (such as the fluctuation amplitude of battery voltage or battery current) brought by a variation by one level (increase or decrease by one level) of the charger is calculated according to the internal resistance of the battery. On this basis, it is possible to calculate how many incremental or decremental output levels the charger needs to be controlled according to the parameter fluctuation amplitude, the real electrical signal parameters of the present battery, and the threshold parameters. Therefore, according to some embodiments of the present disclosure, it is possible to address the inaccurate regulation of the charging parameters of the charger by an accurate calculation of the internal resistance of the battery.

Some embodiments of the present disclosure will be further illustrated with reference to the drawings.

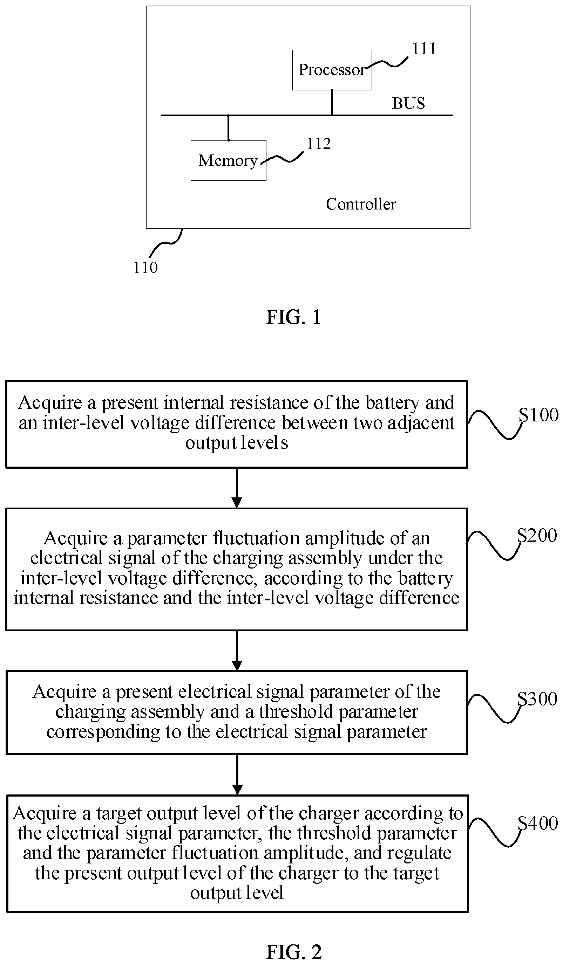

FIG. 1 depicts a schematic diagram showing a controller 110 configured to carry out a method for regulating charging parameters according to an embodiment of the present disclosure.

As shown in FIG. 1, the controller 110 is provided with a processor 111 and a memory 112 connected by a bus or other means. The connection is shown as a bus by way of an example in FIG. 1.

As a non-transitory computer-readable storage medium, the memory 112 can be configured to store non-transitory software programs and non-transitory computer-executable programs. In addition, the memory 112 can include high-speed random-access memory and non-transitory memory, such as at least one disk memory device, flash memory device, or other non-transitory solid-state memory devices. In some implementations, the memory 112 may include memories remotely located relative to the processor 111, and these remote memories may be connected to the controller 110 through a network. Examples of the above networks include, but are not limited to, the Internet, intranet, local area network, mobile communication network, and combinations thereof.

The controller 110 can be applied to a 3G communication network system, LTE communication network system, 5G communication network system, or subsequently evolved mobile communication network systems, etc. This embodiment is not limited thereto.

The controller 110 shown in FIG. 1 does not constitute a limitation to the embodiment of the present disclosure, and may include more or fewer components than those shown, or some components may be combined, or have different component arrangements.

In the controller 110 shown in FIG. 1, the processor 111 can call the program for a method for regulating charging parameters stored in the memory 112, to perform the method for regulating charging parameters.

Based on the controller 110 described above, some embodiments of the terminal device of the present disclosure are proposed below.

In an embodiment of the present disclosure, the terminal device includes, but is not limited to, a charging assembly and the controller discussed above. The controller is in a communicative connection with the charging assembly. The charging assembly includes a battery and a charger configured to charge the battery. The charger is provided with a plurality of output levels.

Based on the above terminal device, some embodiments of the method for regulating charging parameters of the present disclosure are proposed below.

FIG. 2 depicts a flowchart showing a method for regulating charging parameters provided by an embodiment of the present disclosure. The method is applied to a controller in a communicative connection with a charging assembly. The charging assembly includes a battery and a charger. The charger is configured to charge the battery, and is provided with a plurality of output levels. The method includes but is not limited to operations S100, S200, S300 and S400.

At operation S100, a present internal resistance of the battery and an inter-level voltage difference between two adjacent output levels are acquired.

At operation S200, a parameter fluctuation amplitude of an electrical signal of the charging assembly under the inter-level voltage difference is acquired, according to the internal resistance of the battery and the inter-level voltage difference.

At operation S300, a present electrical signal parameter of the charging assembly and a threshold parameter corresponding to the electrical signal parameter are acquired.

At operation S400, a target output level of the charger is acquired according to the electrical signal parameter, the threshold parameter and the parameter fluctuation amplitude, and the present output level of the charger is regulated to the target output level.

In some embodiments of the present disclosure, it is possible to calculate the internal resistance of the battery and to calculate the parameter fluctuation amplitude (such as the fluctuation amplitude of battery voltage or battery current) brought by a variation by one level (increase or decrease by one level) of the charger according to the internal resistance of the battery. On this basis, it is possible to calculate how many incremental or decremental output levels the charger needs to be controlled according to the parameter fluctuation amplitude, the real electrical signal parameters of the present battery, and the threshold parameters. Therefore, according to some embodiments of the present disclosure, it is possible to address the inaccurate regulation of the charging parameters of the charger by an accurate calculation of the internal resistance of the battery.

In an embodiment of the present disclosure, the inter-level voltage difference discussed above refers to the output voltage difference between two adjacent output levels. In an embodiment, the inter-level voltage difference can be an increase in voltage or a decrease in voltage. In an embodiment, the inter-level voltage difference between any two adjacent output levels is identical. For example, the output voltage of the first output level of the charger is 1V and the output voltage of the second output level is 1.5V, so the inter-level voltage difference of the second output level with respect to the first output level equals 0.5V, and the inter-level voltage difference of the first output level with respect to the second output level equals -0.5 V.

In some embodiments, the parameter fluctuation amplitude of the electrical signal of the charging assembly under an inter-level voltage difference, refers to the corresponding fluctuation amplitude of the electrical signal of the charging assembly in response to a regulation of the output voltage by one level.

The above types of electrical signals, parameter fluctuation amplitude, electrical signal parameters, and threshold parameters can include but are not limited to the following four cases.

Case #1: When the electrical signal is the battery current signal of the battery, the parameter fluctuation amplitude corresponds to the parameter fluctuation amplitude in the battery current, the electrical signal parameter corresponds to the present battery current parameter of the battery, and the threshold parameter corresponds to the battery current threshold parameter of the battery.

Case #2: When the electrical signal is the battery voltage signal of the battery, the parameter fluctuation amplitude corresponds to the parameter fluctuation amplitude in the battery voltage, the electrical signal parameter corresponds to the present battery voltage parameter of the battery, and the threshold parameter corresponds to the battery voltage threshold parameter of the battery.

Case #3: When the electrical signal is the output current signal of the charger, the parameter fluctuation amplitude corresponds to the parameter fluctuation amplitude in the charger output current, the electrical signal parameter corresponds to the present charger output current parameter of the charger, and the threshold parameter corresponds to the charger output current threshold parameter of the charger.

Case #4: When the electrical signal is the output voltage signal of the charger, the parameter fluctuation amplitude corresponds to the parameter fluctuation amplitude in the charger output voltage, the electrical signal parameter corresponds to the present charger output voltage parameter of the charger, and the threshold parameter corresponds to the charger output voltage threshold parameter of the charger.

In addition, the above threshold parameters may be preset threshold values.

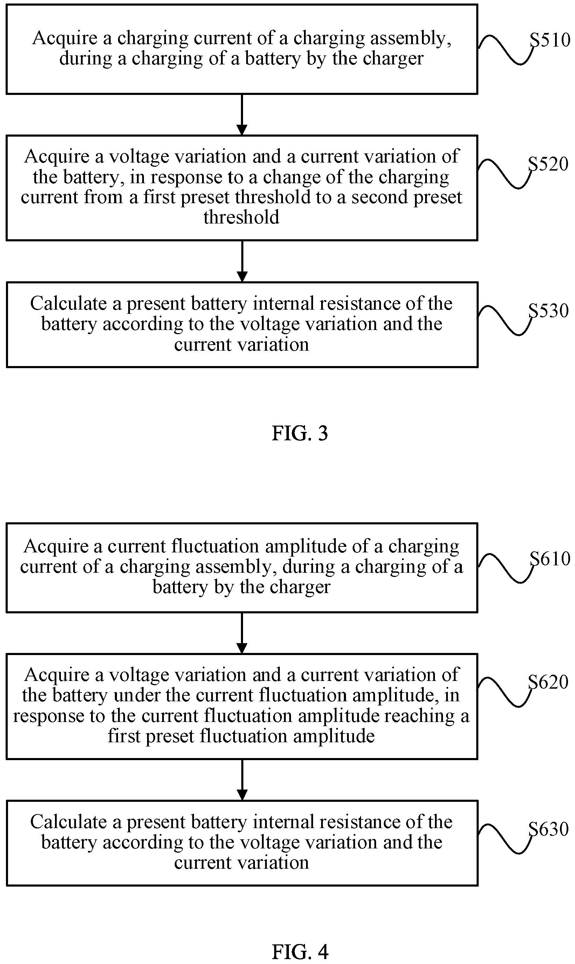

In addition, the acquisition of the present internal resistance of the battery involved in the above operation S100, can be carried out through the method described with respect to any one of FIGS. 3 to 5.

FIG. 3 depicts a flowchart showing an acquisition of the battery internal resistance in a method for regulating a charging parameter according to an embodiment of the present disclosure. The acquisition of the present battery internal resistance of the battery involved in the above operation S100 includes but is not limited to operation S510, operation S520, and operation S530.

At operation S510, a charging current of a charging assembly is acquired, during a charging of a battery by the charger.

At operation S520, a voltage variation and a current variation of the battery are acquired, in response to a change of the charging current from a first preset threshold to a second preset threshold.

At operation S530, the present battery internal resistance of the battery is calculated according to the voltage variation and the current variation.

In an embodiment of the present disclosure, the present battery internal resistance of the battery can be calculated passively. During a charging process from an initial stage of charging (i.e., the charging current increases from 0), to a stage when the charging current reaches a certain threshold, the battery internal resistance can be calculated by the following equation: Rbatt=ΔVbatt/ΔIbatt, where Rbatt is the battery internal resistance, ΔVbatt is the voltage variation, and ΔIbatt is the current variation.

The first preset threshold and the second preset threshold may be preset thresholds. The first preset threshold may be different from the second preset threshold. When the first preset threshold is zero, it is indicated that the present internal resistance of the battery is calculated from the initial stage of charging, that is, the charging current increases from 0.

FIG. 4 depicts a flowchart showing an acquisition of the battery internal resistance in a method for regulating a charging parameter according to another embodiment of the present disclosure. The acquisition of the present battery internal resistance of the battery involved in the above operation S100 includes but is not limited to operation S610, operation S620, and operation S630.

At operation S610, a current fluctuation amplitude of a charging current of a charging assembly is acquired, during a charging of a battery by the charger.

At operation S620, a voltage variation and a current variation of the battery under the current fluctuation amplitude are acquired, in response to the current fluctuation amplitude reaching a first preset fluctuation amplitude.

At operation S630, the present internal resistance of the battery is calculated according to the voltage variation and the current variation.

In an embodiment of the present disclosure, the present battery internal resistance of the battery can be calculated passively. During charging, if the charging current fluctuates beyond a certain threshold due to heating or current limiting, the voltage variation and current variation of the battery under the current fluctuation amplitude can be acquired, and the battery internal resistance can be calculated by the following equation: Rbatt=ΔVbatt/ΔIbatt, where Rbatt is the battery internal resistance, ΔVbatt is the voltage variation, and ΔIbatt is the current variation.

The first preset fluctuation amplitude may be a preset fluctuation threshold.

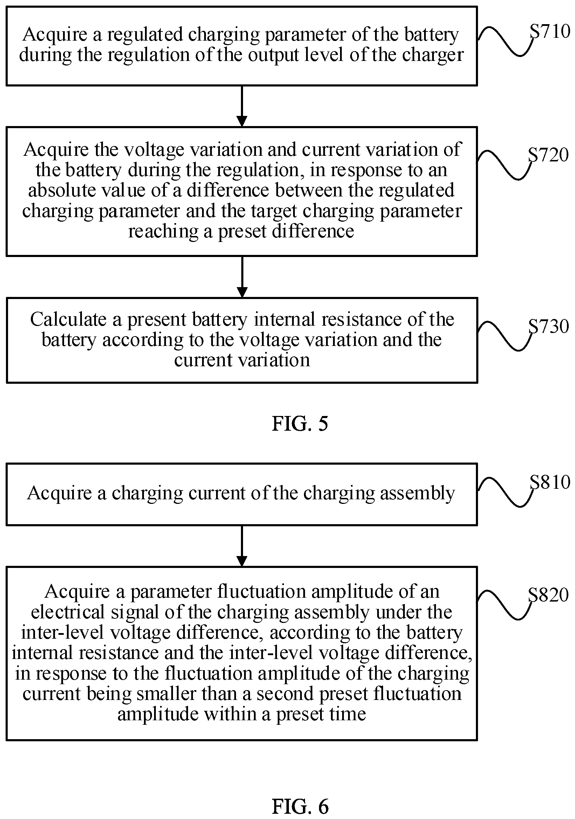

FIG. 5 depicts a flowchart showing an acquisition of the battery internal resistance in a method for regulating a charging parameter according to another embodiment of the present disclosure. The acquisition of the present battery internal resistance of the battery involved in the above operation S100 includes but is not limited to operation S710, operation S720, and operation S730.

At operation S710, a regulated charging parameter of the battery is acquired during the regulation of the output level of the charger.

At operation S720, the voltage variation and current variation of the battery during the regulation are acquired, in response to an absolute value of a difference between the regulated charging parameter and the target charging parameter reaching a preset difference.

At operation S730, the present battery internal resistance of the battery is calculated according to the voltage variation and the current variation.

In an embodiment of the present disclosure, the present battery internal resistance of the battery can be calculated proactively. In particular, when a huge difference between the charging parameter of the battery and the target value after the voltage regulation is found during the regulation of the voltage by a software algorithm, the charging parameter is proactively lowered to a certain threshold to obtain the voltage variation and current variation of the battery during the regulation. The battery internal resistance is calculated by the following equation: Rbatt=ΔVbatt/ΔIbatt, where Rbatt is the battery internal resistance, ΔVbatt is the voltage variation, and ΔIbatt is the current variation.

The above charging parameters may include but are not limited to, battery voltage parameters or battery current parameters.

In addition, the preset difference may be a preset difference threshold.

FIG. 6 depicts a flowchart showing a calculation of parameter fluctuation amplitude during the stable constant current stage in a method for regulating a charging parameter according to an embodiment of the present disclosure. The above operation S200 includes but is not limited to operation S810 and operation S820.

At operation S810, a charging current of the charging assembly is acquired.

At operation S820, a parameter fluctuation amplitude of an electrical signal of the charging assembly under the inter-level voltage difference is acquired, according to the internal resistance of the battery and the inter-level voltage difference, in response to the fluctuation amplitude of the charging current being less than a second preset fluctuation amplitude within a preset time.

It is possible to calculate the parameter fluctuation amplitude according to the internal resistance of the battery and the inter-level voltage difference in the stable constant current stage of charging. In this regard, in an embodiment of the present disclosure, the charging current of the charging assembly is further acquired. If the fluctuation amplitude of the charging current within the preset time is less than the second preset fluctuation amplitude, it indicates that the charging is currently in a stable constant current stage. Then the controller calculates the parameter fluctuation amplitude of the electrical signal of the charging assembly under the inter-level voltage difference according to the battery internal resistance and the inter-level voltage difference during the stable constant current stage during charging.

The second preset fluctuation amplitude may be a preset fluctuation threshold.

In an embodiment, the electrical signal as discussed above includes but is not limited to any one of the battery current signal, battery voltage signal, charger output current signal, or charger output voltage signal. The following four calculations for parameter fluctuation amplitude are provided.

Case#1: When the electrical signal is the battery current signal of the battery, the fluctuation amplitude of the battery current parameter is calculated by the following equation: ΔIbatt'≈(Vchg_step/2)/Rbatt, where ΔIbatt' is the fluctuation amplitude of the battery current parameter, Vchg_step is the inter-level voltage difference, and Rbatt is the battery internal resistance.

Case#2: When the electrical signal is the battery voltage signal of the battery, the fluctuation amplitude of the battery voltage parameter is calculated by the following equations: ΔVbatt'≈Vchg_step/2+ΔIbatt'*Rbatt, and ΔIbatt'≈(Vchg_step/2)/Rbatt, where ΔVbatt' is the fluctuation amplitude of the battery voltage parameter, Vchg_step is the inter-level voltage difference, ΔIbatt' is the fluctuation amplitude of the battery current parameter, and Rbatt is the battery internal resistance.

Case#3: When the electrical signal is the charger output current signal of the charger, the fluctuation amplitude of the charger output current parameter is calculated by the following equations: ΔIbus≈ΔIbatt'*2, and ΔIbatt'≈(Vchg_step/2)/Rbatt, where ΔIbus is the fluctuation amplitude of the charger output current parameter, ΔIbatt' is the fluctuation amplitude of the battery current parameter, Vchg_step is the inter-level voltage difference, and Rbatt is the battery internal resistance.

Case#4: When the electrical signal is the charger output voltage signal of the charger, the fluctuation amplitude of the charger output voltage parameter is calculated by the following equations: ΔVbus≈ΔVbatt'*2, ΔVbatt'≈Vchg_step/2 +ΔIbatt'*Rbatt, and ΔIbatt'≈(Vchg_step/2)/Rbatt, where ΔVbus is the fluctuation amplitude of the charger output voltage parameter, ΔVbatt' is the fluctuation amplitude of the battery voltage parameter, Vchg_step is the inter-level voltage difference, ΔIbatt' is the fluctuation amplitude of the battery current parameter, and Rbatt is the battery internal resistance.

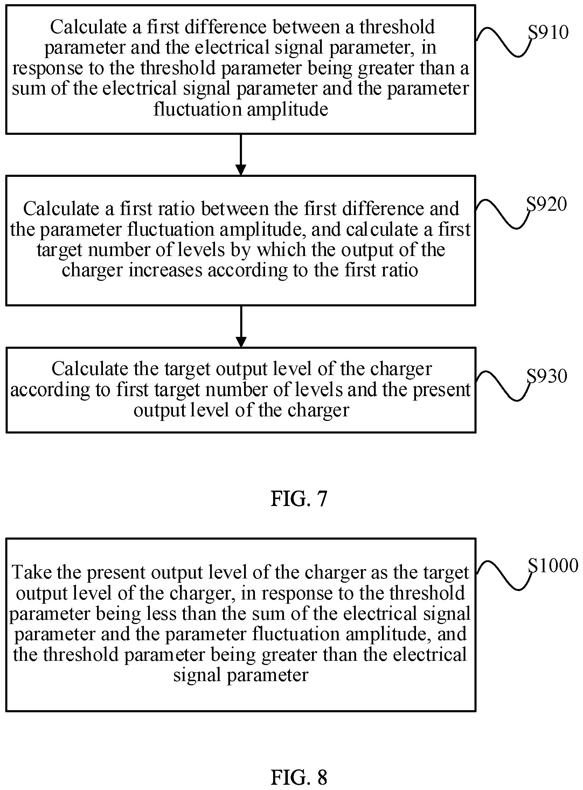

In an embodiment, operation S400 as discussed above further includes the operations described with respect to any one of FIGS. 7 to 9.

FIG. 7 depicts a flowchart showing a calculation of the target output level in a method for regulating a charging parameter according to an embodiment of the present disclosure. The above operation S400 includes but is not limited to operation 910, operation S920, and operation S930.

At operation S910, a first difference between a threshold parameter and the electrical signal parameter is calculated, in response to the threshold parameter being greater than the sum of the electrical signal parameter and the parameter fluctuation amplitude.

At operation S920, a first ratio between the first difference and the parameter fluctuation amplitude is calculated, and a first target number of levels by which the output of the charger increases is calculated according to the first ratio.

At operation S930, the target output level of the charger is calculated according to the first target number of levels and the present output level of the charger.

FIG. 8 depicts a flowchart showing a calculation of the target output level in a method for regulating a charging parameter according to another embodiment of the present disclosure. The above operation S400 includes but is not limited to operation S1000.

At operation S 1000, the present output level of the charger is taken as the target output level of the charger, in response to the threshold parameter being less than the sum of the electrical signal parameter and the parameter fluctuation amplitude, and the threshold parameter being greater than the electrical signal parameter.

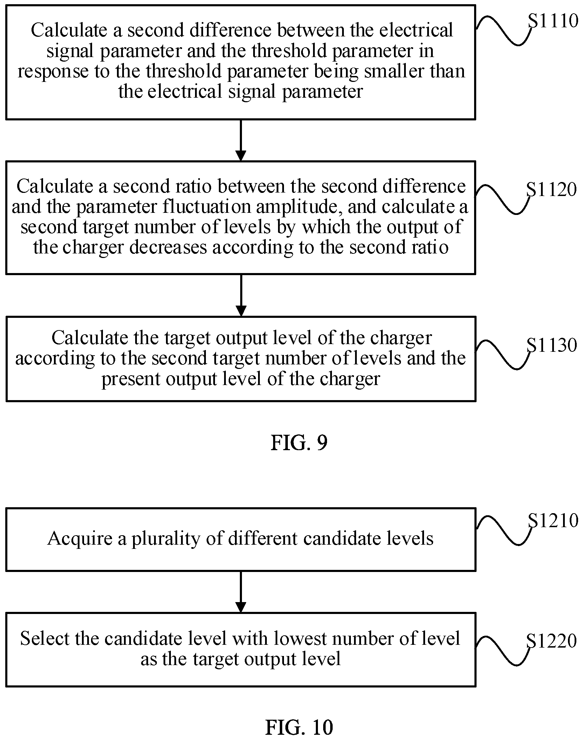

FIG. 9 depicts a flowchart showing a calculation of the target output level in a method for regulating a charging parameter according to another embodiment of the present disclosure. The above operation S400 includes but is not limited to operation 1110, operation S1120, and operation 51130.

At operation S1110, a second difference between the electrical signal parameter and the threshold parameter is calculated in response to the threshold parameter being less than the electrical signal parameter.

At operation S1120, a second ratio between the second difference and the parameter fluctuation amplitude is calculated, and a second target number of levels by which the output of the charger decreases is calculated according to the second ratio.

At operation S1130, the target output level of the charger is calculated according to the second target number of levels and the present output level of the charger.

Based on the three schemes discussed with respect to FIGS. 7 to 9, the electrical signal as discussed above includes but is not limited to any one of the battery current signal, battery voltage signal, charger output current signal, or charger output voltage signal. The following four calculations for the target output level are provided.

First, in the case that the electrical signal is a battery current signal, it is possible to determine whether to increase or decrease the output voltage of the charger according to the real-time current Ibatt of the battery and the current fluctuation ΔIbatt' brought by a variation by one level.

When the battery current threshold parameter Ibatt_ocp_alm > Ibatt +ΔIbatt', the number of levels by which the output of the charger increases can be calculated through the equation num = (Ibatt_ocp_alm - Ibatt)/ΔIbatt'.

When the battery current threshold parameter Ibatt_ocp_alm < Ibatt +ΔIbatt' and Ibatt_ocp_alm > Ibatt, the voltage can be kept unchanged, that is, the present output level can be kept unchanged.

When the battery current threshold parameter Ibatt_ocp_alm< Ibatt, the number of levels by which the charger decreases can be calculated through the equation: num = (Ibatt - Ibatt_ocp_alm)/ ΔIbatt'.

Second, in the case that the electrical signal is a battery voltage signal, it is possible to determine whether to increase or decrease the output voltage of the charger according to the real-time voltage Vbatt of the battery and the voltage fluctuation ΔVbatt' brought by a variation by one level.

When the battery voltage threshold parameter Vbatt_ovp_alm > Vbatt+ΔVbatt', the number of levels by which the output of the charger increases can be calculated through the equation: num = (Vbatt_ovp_alm - Vbatt)/ΔVbatt'.

When the battery voltage threshold parameter Vbatt_ovp_alm < Vbatt+ΔVbatt' and Vbatt_ovp_alm > Vbatt, the voltage can be kept unchanged, that is, the present output level can be kept unchanged.

When the battery voltage threshold parameter Vbatt_ovp_alm < Vbatt, the number of levels by which the charger decreases can be calculated through the equation: num =(Vbatt - Vbatt_ovp_alm)/ΔVbatt'.

Third, in the case that the electrical signal is the output current signal of the charger, it is possible to determine whether to increase or decrease the output voltage of the charger according to the real-time current Ibus of the charger and the charger output current fluctuation ΔIbus brought by a variation by one level.

When the charger output current threshold parameter Ibus_ocp_alm > Ibus +ΔIbus, the number of levels by which the output of the charger increases can be calculated through the equation: num =(Ibus_ocp_alm-Ibus)/ΔIbus.

When the charger output current threshold parameter Ibus_ocp_alm < Ibus +ΔIbus and Ibus_ocp_alm > Ibus, the voltage can be kept unchanged, that is, the present output level can be kept unchanged.

When the charger output current threshold parameter Ibus_ocp_alm < Ibus, the number of levels by which the charger decreases can be calculated through the equation: num =(Ibus-Ibus_ocp_alm)/ΔIbus.

Fourth, in the case that the electrical signal is the output voltage signal of the charger, it is possible to determine whether to increase or decrease the output voltage of the charger according to the real-time voltage Vbus of the charger and the charger output voltage fluctuation ΔVbus brought by a variation by one level.

When the charger output voltage threshold parameter Vbus_ovp_alm > Vbus +ΔVbus, the number of levels by which the output of the charger increases can be calculated through the equation: num =(Vbus_ovp_alm - Vbus)/ΔVbus.

When the charger output voltage threshold parameter Vbus_ovp_alm < Vbus +ΔVbus and Vbus_ovp_alm > Vbus, the voltage can be kept unchanged, that is, the present output level can be kept unchanged.

When the charger output voltage threshold parameter Vbus _ovp_alm < Vbus, the number of levels by which the output of the charger decreases can be calculated through the equation: num =(Vbus - Vbus_ovp_alm)/ΔVbus.

FIG. 10 depicts a flowchart showing a selection of the target output level from a plurality of candidate levels in a method for regulating a charging parameter according to an embodiment of the present disclosure. In an embodiment, the electrical signal is included a plurality of different electric signals. The target output level is included in a plurality of different candidate levels. Each of the plurality of electric signals corresponds to a respective one of the plurality of candidate levels. In an embodiment, the method for regulating a charging parameter further includes, but is not limited to, operation S 1210 and operation S 1220.

At S 1210, a plurality of different candidate levels are acquired.

At operation S 1220, the candidate level with the lowest number of level is selected as the target output level.

In an embodiment, the electrical signal as discussed above includes but is not limited to any one case of battery current signal, battery voltage signal, charger output current signal, or charger output voltage signal. Therefore, corresponding candidate levels are provided for each case. In an embodiment of the present disclosure, the minimum value after considering each condition can be selected as the number of levels to increase or decrease, while ensuring that Ibatt_ocp_alm, Vbatt_ovp_alm, Ibus_ocp_alm, and Vbus_ovp_alm do not exceed the standard. In this way, it is ensured that the battery can be charged according to the maximum charging parameters.

Based on the above-described method for regulating a charging parameter, several embodiments regarding a controller, a terminal device, and a computer-readable storage medium are provided below.

According to an embodiment of the present disclosure, a controller is provided. The controller includes a memory, a processor, and a computer program stored in the memory and executable by the processor which, when executed by the processor causes the processor to carry out any one of the methods as described above.

The processor and the memory may be connected by a bus or other means.

The controller in this embodiment can correspond to the controller in the embodiment shown in FIG. 1, both of which belong to the same concept, so they have the same implementing principle and beneficial effects, and will not be described in detail here.

Non-transitory software programs and instructions for the method for regulating a charging parameter described in any one of the above embodiments are stored in a memory which, when executed by a processor, causes the processor to carry out the method for regulating a charging parameter, e.g., the operations described in conjunction with FIG. 2 to FIG. 10.

The implementation and corresponding technical effects of the controller in this embodiment of the present disclosure can be referred to the embodiments as described with respect to the method for regulating a charging parameter described above.

According to an embodiment of the present disclosure, a terminal device is provided. The terminal device includes but is not limited to the controller as described above.

It is to be noted that the implementation and corresponding technical effects of the terminal device in this embodiment of the present disclosure correspond to the embodiments as described with respect to the method for regulating a charging parameter above, due to the controller that is included in the terminal device for implementing the method for regulating a charging parameter.

According to an embodiment of the present disclosure, a computer-readable storage medium is provided. The computer-readable storage medium stores computer-executable instruction which, when executed by a processor, causes the processor to carry out the operations of the method described above, for example, the above operations described with respect to FIGS. 2 to 10.

According to an embodiment of the present disclosure, the method includes the following operations. The controller first acquires a present battery internal resistance of the battery and an inter-level voltage difference between two adjacent output levels. Then, the controller calculates a parameter fluctuation amplitude of an electrical signal of the charging assembly under the inter-level voltage difference, according to the internal resistance of the battery and the inter-level voltage difference. Then, the controller acquires a present electrical signal parameter of the charging assembly and a threshold parameter corresponding to the electrical signal parameter. Finally, the controller acquires a target output level of the charger according to the electrical signal parameter, the threshold parameter and the parameter fluctuation amplitude, and regulates a present output level of the charger to the target output level. According to an embodiment of the present disclosure, the parameter fluctuation amplitude (such as the fluctuation amplitude of battery voltage or battery current) brought by a variation by one level (increase or decrease by one level) of the charger is calculated according to the internal resistance of the battery. On this basis, it is possible to calculate how many incremental or decremental output levels the charger needs to be controlled according to the parameter fluctuation amplitude, the present real electrical signal parameters of the battery, and the threshold parameters. Therefore, according to some embodiment of the present disclosure, it is possible to address the inaccurate regulation of the charging parameters of the charger by an accurate calculation of the internal resistance of the battery.

It shall be appreciated by a person having ordinary skills in the art that all or some of the steps and systems disclosed above can be implemented as software, firmware, hardware, and their appropriate combinations. Some or all physical components can be implemented as software executed by a processor, such as a central processing unit, a digital signal processor, or a microprocessor, or as hardware, or as an integrated circuit, such as an application-specific integrated circuit. Such software can be distributed on computer-readable media, which can include computer storage media (or non-transitory media) and communication media (or transitory media). As is well known to a person having ordinary skills in the art, the term computer storage medium includes volatile and nonvolatile, removable and non-removable medium implemented in any method or technology for storing information such as computer-readable instructions, data structures, program modules, or other data. Computer storage medium includes but is not limited to, RAM, ROM, EEPROM, flash memory or other memory technologies, CD-ROM, digital versatile disks (DVD) or other optical disk storage, magnetic boxes, tapes, magnetic disk storage or other magnetic storage devices, or any other medium that can be configured to store desired information and accessible by a computer. Furthermore, communication media usually contains computer-readable instructions, data structures, program modules, or other data in modulated data signals such as carrier waves or other transmission mechanisms, and can include any information delivery media.

Described above is a description of several embodiments of the present disclosure, but the present disclosure is not limited to the above embodiments. Those having ordinary skills in the art can make various equivalent modifications or substitutions without departing the scope of the present disclosure, and these equivalent modifications or substitutions are within the scope defined by the claims of the present disclosure.

## Claims

1. A method for regulating a charging parameter, which is applied to a controller, wherein the controller is in communicative connection with a charging assembly, the charging assembly comprises a battery and a charger configured to charge the battery, the charger is configured with a plurality of output levels, and the method comprises:
acquiring a present battery internal resistance of the battery and an inter-level voltage difference between two adjacent output levels;
acquiring a parameter fluctuation amplitude of an electrical signal of the charging assembly under the inter-level voltage difference, according to the battery internal resistance and the inter-level voltage difference;
acquiring a present electrical signal parameter of the charging assembly and a threshold parameter corresponding to the electrical signal parameter; and
acquiring a target output level of the charger according to the electrical signal parameter, the threshold parameter and the parameter fluctuation amplitude, and regulating a present output level of the charger to the target output level.

2. The method as claimed in claim 1, wherein acquiring the present battery internal resistance of the battery comprises:
acquiring a charging current of the charging assembly during a charging of the battery by the charger;
acquiring a voltage variation and a current variation of the battery, in response to a change of the charging current from a first preset threshold to a second preset threshold; and
calculating the present battery internal resistance of the battery according to the voltage variation and the current variation.

3. The method as claimed in claim 1, wherein acquiring the present battery internal resistance of the battery comprises:
acquiring a current fluctuation amplitude of a charging current of the charging assembly, during a charging of the battery by the charger;
acquiring a voltage variation and a current variation of the battery under the current fluctuation amplitude, in response to the current fluctuation amplitude reaching a first preset fluctuation amplitude; and
calculating the present battery internal resistance of the battery according to the voltage variation and the current variation.

4. The method as claimed in claim 1, wherein acquiring the present battery internal resistance of the battery comprises:
acquiring a regulated charging parameter of the battery during a regulation of the output levels of the charger;
acquiring a voltage variation and a current variation of the battery during the regulation, in response to an absolute value of a difference between the regulated charging parameter and a target charging parameter reaching a preset difference; and
calculating the present battery internal resistance of the battery according to the voltage variation and the current variation.

5. The method as claimed in claim 1, wherein acquiring the parameter fluctuation amplitude of the electrical signal of the charging assembly under the inter-level voltage difference, according to the battery internal resistanceand the inter-level voltage difference comprises:
acquiring a charging current of the charging assembly;
acquiring the parameter fluctuation amplitude of the electrical signal of the charging assembly under the inter-level voltage difference, according to the battery internal resistance of and the inter-level voltage difference, in response to a fluctuation amplitude of the charging current being less than a second preset fluctuation amplitude within a preset time.

6. The method as claimed in claim 1, wherein acquiring the target output level of the charger according to the electrical signal parameter, the threshold parameter and the parameter fluctuation amplitude comprises:
calculating a first difference between the threshold parameter and the electrical signal parameter, in response to the threshold parameter being greater than a sum of the electrical signal parameter and the parameter fluctuation amplitude;
calculating a first ratio between the first difference and the parameter fluctuation amplitude, and calculating a first target number of levels by which an output of the charger increases according to the first ratio; and
calculating the target output level of the charger according to the first target number of levels and the present output level of the charger.

7. The method as claimed in claim 1, wherein acquiring the target output level of the charger according to the electrical signal parameter, the threshold parameter and the parameter fluctuation amplitude comprises:
taking the present output level of the charger as the target output level of the charger, in response to the threshold parameter being less than a sum of the electrical signal parameter and the parameter fluctuation amplitude, and the threshold parameter being greater than the electrical signal parameter.

8. The method as claimed in claim 1, wherein acquiring the target output level of the charger according to the electrical signal parameter, the threshold parameter and the parameter fluctuation amplitude comprises:
calculating a second difference between the electrical signal parameter and the threshold parameter, in response to the threshold parameter being less than the electrical signal parameter;
calculating a second ratio between the second difference and the parameter fluctuation amplitude, and calculating a second target number of levels by which an output of the charger decreases according to the second ratio; and
calculating the target output level of the charger according to the second target number of levels and the present output level of the charger.

9. The method as claimed in claim 1, wherein the electrical signal is comprised in one of a plurality of different electric signals, the target output level is comprised in a plurality of different candidate levels, and each of the plurality of electric signals corresponds to a respective one of the plurality of candidate levels, and the method further comprises:
acquiring the plurality of different candidate levels;
selecting a candidate level having lowest number of level, from the plurality of different candidate levels as the target output level.

10. The method as claimed in any one of claims 1 to 9, further comprising one of
when the electrical signal is a battery current signal of the battery, the parameter fluctuation amplitude corresponds to the parameter fluctuation amplitude in battery current, the electrical signal parameter corresponds to a present battery current parameter of the battery, and the threshold parameter corresponds to a battery current threshold parameter of the battery; or
when the electrical signal is a battery voltage signal of the battery, the parameter fluctuation amplitude corresponds to the parameter fluctuation amplitude in battery voltage, the electrical signal parameter corresponds to a present battery voltage parameter of the battery, and the threshold parameter corresponds to a battery voltage threshold parameter of the battery; or
when the electrical signal is a charger output current signal of the charger, the parameter fluctuation amplitude corresponds to the parameter fluctuation amplitude in charger output current, the electrical signal parameter corresponds to a present charger output current parameter of the charger, and the threshold parameter corresponds to a charger output current threshold parameter of the charger; or
when the electrical signal is a charger output voltage signal of the charger, the parameter fluctuation amplitude corresponds to the parameter fluctuation amplitude in charger output voltage, the electrical signal parameter corresponds to a present charger output voltage parameter of the charger, and the threshold parameter corresponds to a charger output voltage threshold parameter of the charger.

11. A controller, comprising a memory, a processor and a computer program stored in the memory and executable by the processor which, when executed by the processor causes the processor to carry out the method as claimed in any one of claims 1 to 10.

12. A terminal device comprising the controller as claimed in claim 11.

13. A computer-readable storage medium storing a computer-executable instruction which, when executed by a processor, causes the processor to carry out the method as claimed in any one of claims 1 to 10.
